# EUROPEAN PATENT APPLICATION

(11) **EP 4 284 124 A1**
(43) Date of publication of application: **29.11.2023**
(21) Application number: 22742827.3
(22) Date of filing: 19.01.2022
(51) Int. Cl.: H05K 1/16, H01F 17/00, H01F 27/28

(54) **COIL SUBSTRATE**

(30) Priority: 20.01.2021 KR 20210008192
(71) Applicant: LG Electronics Inc., Yeongdeungpo-gu Seoul 07336 (KR)
(72) Inventor: KANG, Byeong Geuk, Seoul 08592 (KR); JANG, Younseok, Seoul 08592 (KR)
(74) Representative: Vossius & Partner Patentanwälte Rechtsanwälte mbB
(86) International application number: PCT/KR2022/000989
(87) International publication number: WO 2022/158851

(57) **Abstract**

The present specification relates to a coil substrate. A coil substrate according to one embodiment of the present specification comprises: a substrate; and a coil which is mounted on one surface of the substrate and comprises a plurality of turns, wherein the plurality of turns comprise a first inner turn located at the innermost side of the coil and a first outer turn located at the outermost side of the coil, wherein the first inner turn comprises a greater number of patterns than the first outer turn.

## Description

### [Technical Field]

The present specification relates to a coil substrate.

### [Background Art]

A coil, which is a closed ring-shaped conductor made of a metal wire in which current may flow, is mostly used to wirelessly transfer or receive energy in electronic devices such as an induction heating cooker, a wireless charger, and a smartphone. A typical coil is manufactured in a spiral shape like a spring and thus has a large volume. Here, in order to reduce the volume occupied by the coil in an electronic device, a coil substrate manufactured by printing a coil on one surface of a substrate using a metal thin film may be used inside the electronic device.

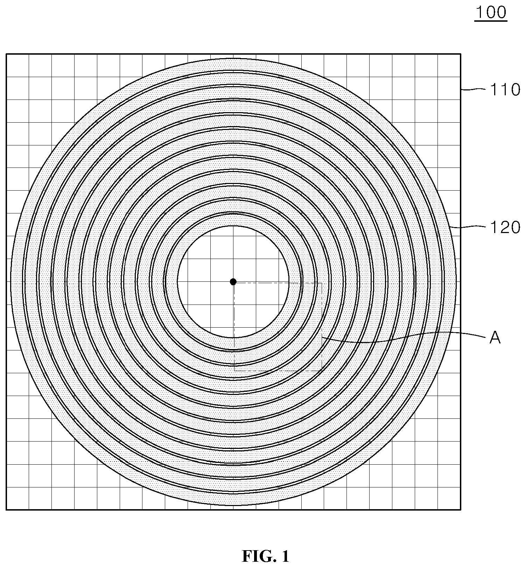

One embodiment of an electronic device in which a coil substrate is used is disclosed in Korean Patent Publication No. 10-2017-0019826A. A typical form of the coil substrate used in the publicized patent may be described in more detail with reference to FIG. 1.

FIG. 1 is a view illustrating a coil substrate according to one embodiment of the related art.

Referring to FIG. 1, a coil substrate 100 includes a substrate 110 and a coil 120. The coil 120 may be formed by being printed on the substrate 110. Here, the coil 120 may include a plurality of turns.

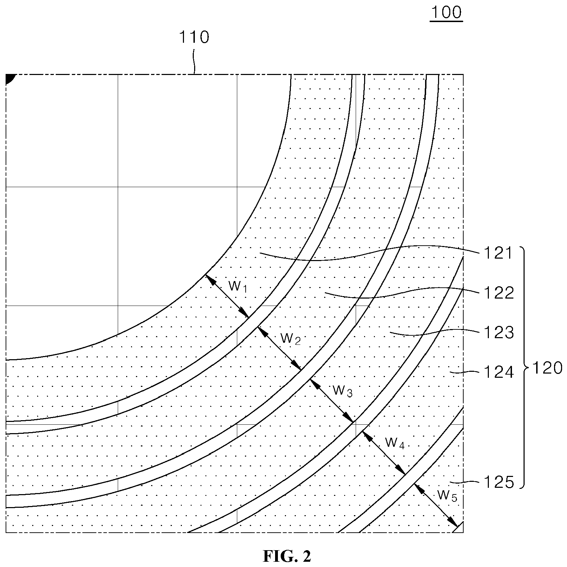

Here, the plurality of turns on the coil 120 may have the same center and shape but have different sizes. This may be described in more detail with reference to FIG. 2.

FIG. 2 is an enlarged view of portion "A" of FIG. 1.

Referring to FIG. 2, the turns disposed at the center of the coil 120 may be checked in more detail. The plurality of turns may include a first turn 121 disposed at an innermost side of the coil 120, a second turn 122 disposed right outside the first turn 121, a third turn 123 disposed right outside the second turn 122, a fourth turn 124 disposed right outside the third turn 123, and a fifth turn 125 disposed right outside the fourth turn 124.

Here, the plurality of turns have the same width. That is, a width W₁ of the first turn 121, a width W₂ of the second turn 122, a width W₃ of the third turn 123, a width W₄ of the fourth turn 124, and a width W₅ of the fifth turn 125 may all have the same value.

That is, the plurality of turns may have the same center, shape, and width but have circular shapes with different diameter sizes.

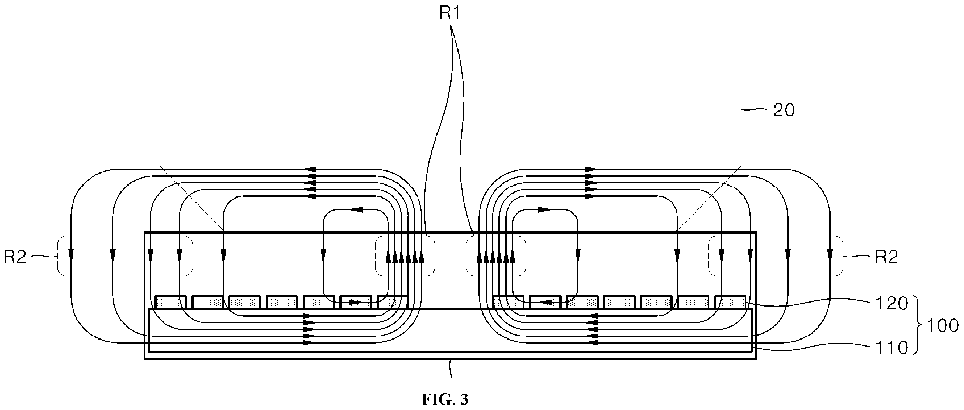

A magnetic field formed in a case in which the coil substrate 100 is used may be as shown in FIG. 3.

FIG. 3 is a view illustrating a magnetic field formed due to the coil substrate according to one embodiment of the related art.

Referring to FIG. 3, in a case in which a cooking container 20 is placed on a cooking device 10 including the coil substrate 100, a magnetic field formed due to the coil substrate 100 may be checked.

Here, it can be seen that the magnetic field is densely formed in an area R1 in the vicinity of the center of the coil 120 and is loosely formed in an area R2 in the vicinity of an outer periphery of the coil 120.

Since the magnetic field is densely formed in the area R1 in the vicinity of the center of the coil 120, excessive heat is generated in the area R1 in the vicinity of the center of the coil 120. This may cause the cooking device 10 using the coil substrate 100 to be overheated and stop operating.

Also, since excessive heat is generated in the area R1 in the vicinity of the center of the coil 120, energy that is lost without being transferred to the cooking container 20 increases. That is, the excessive heat causes a reduction of energy efficiency of the cooking device 10 using the coil substrate 100.

Also, when excessive heat is generated in the area R1 in the vicinity of the center of the coil 120, as the overall temperature of the cooking device 10 rises, the cooking device 10 may suddenly turn off due to an overheating prevention logic included in the cooking device 10.

In summary, when the coil substrate 100 having the coil 120 formed thereon illustrated in FIG. 1 is used, there are problems that excessive heat is generated, energy efficiency is reduced due to the excessive heat, and the electronic device suddenly turns off.

### [Disclosure]

### [Technical Problem]

The present specification is directed to providing a coil substrate in which excessive heat is not generated in an area in the vicinity of the center of a coil.

The present specification is also directed to providing a coil substrate with low energy loss.

The present specification is also directed to providing a coil substrate capable of preventing an electronic device using the coil substrate from being suddenly turned off due to overheating of the coil substrate.

Objectives of the present specification are not limited to the above-mentioned objectives, and other unmentioned objectives of the present specification and advantages thereof may be understood by the description below and should be more clearly understood from embodiments of the present specification. Also, it should be easily understood that the objectives and advantages of the present specification may be realized by means described in the claims below and combinations thereof.

### [Technical Solution]

In a coil substrate of the present specification, a first inner turn includes a larger number of patterns than a first outer turn.

According to such a configuration, excessive heat generation in an area in the vicinity of the center of a coil can be prevented, and simultaneously, energy efficiency of a coil substrate can be improved.

According to one embodiment of the present specification, a coil substrate includes a substrate and a coil mounted on one surface of the substrate and including a plurality of turns, wherein the plurality of turns include a first inner turn disposed at an innermost side of the coil and a first outer turn disposed at an outermost side of the coil, and the first inner turn includes a larger number of patterns than the first outer turn.

Also, in one embodiment of the present specification, the plurality of turns of the coil substrate may have the same width.

Also, in one embodiment of the present specification, the first inner turn of the coil substrate may include a plurality of patterns, and the first outer turn may include a single pattern.

Also, in one embodiment of the present specification, the plurality of patterns included in the first inner turn of the coil substrate may have the same width.

Also, in one embodiment of the present specification, the plurality of turns of the coil substrate may further include a second inner turn disposed right outside the first inner turn, and the second inner turn may include a larger number of patterns than the first outer turn but include a smaller number of patterns than the first inner turn.

Also, in one embodiment of the present specification, the plurality of turns of the coil substrate may further include a third inner turn disposed right outside the second inner turn, and the third inner turn may include a larger number of patterns than the first outer turn but include a smaller number of patterns than the second inner turn.

Also, in one embodiment of the present specification, the plurality of turns of the coil substrate may further include a second outer turn disposed right inside the first outer turn, and the second outer turn may include the same number of patterns as the first outer turn.

In addition, in one embodiment of the present specification, the plurality of turns of the coil substrate may have the same thickness.

### [Advantageous Effects]

In a coil substrate according to the present specification, since a first inner turn includes a larger number of patterns than a first outer turn, there is an advantage that excessive heat is not generated in an area in the vicinity of the center of a coil.

Also, the coil substrate according to the present specification has an advantage that energy loss is low.

In addition, the coil substrate according to the present specification has an advantage that it is possible to prevent an electronic device using the coil substrate from suddenly turning off.

### [Description of Drawings]

FIG. 1 is a view illustrating a coil substrate according to one embodiment of the related art.
FIG. 2 is an enlarged view of portion "A" of FIG. 1.
FIG. 3 is a view illustrating a magnetic field formed due to the coil substrate according to one embodiment of the related art.
FIG. 4 is a view illustrating a coil substrate according to one embodiment of the present specification.
FIG. 5 is an enlarged view of portion "B" of FIG. 4.
FIG. 6 is an enlarged view of portion "C" of FIG. 4.
FIG. 7 is a graph showing changes in the temperature of the center of a coil when energy is transferred through the coil substrates according to one embodiment of the related art and one embodiment of the present specification.

### [Modes of the Invention]

The objectives, features, and advantages will be described in detail below with reference to the accompanying drawings, and accordingly, those of ordinary skill in the art to which the present specification pertains should be able to easily practice the technical idea of the present specification. In describing the present specification, when it is determined that detailed description of a known art related to the present specification may unnecessarily obscure the gist of the present specification, the detailed description thereof will be omitted. Hereinafter, exemplary embodiments according to the present specification will be described in detail with reference to the accompanying drawings. In the drawings, the same reference numerals are used to indicate the same or similar components.

Although terms such as first and second are used to describe various components, of course, the components are not limited by the terms. The terms are only used to distinguish one component from another component, and of course, a first component may also be a second component unless otherwise stated.

Hereinafter, when an arbitrary configuration is described as being disposed on an "upper portion (or lower portion)" of a component or being disposed "on (or under)" the component, this may not only mean that the arbitrary configuration is disposed in contact with an upper surface (or lower surface) of the component but may also mean that another configuration may be interposed between the component and the arbitrary configuration disposed on (or under) the component.

Also, when a certain component is described as being "connected," "coupled," or "linked" to another component, this may mean that the component is directly connected or linked to the other component but may also mean that the component is "connected," "coupled," or "linked" to the other component via another component "interposed" therebetween or the component and the other component are "connected," "coupled," or "linked" through other components.

Throughout the specification, unless otherwise stated, the number of each component may be singular or plural.

A singular expression used in the present specification includes a plural expression unless the context clearly indicates otherwise. In this application, terms such as "consist of" or "include" should not be construed as indicating that all of various components or various operations described herein are necessarily included, and should be construed as indicating that some components or some operations may not be included or additional components or operations may be further included.

Hereinafter, a coil substrate according to some embodiments of the present specification will be described.

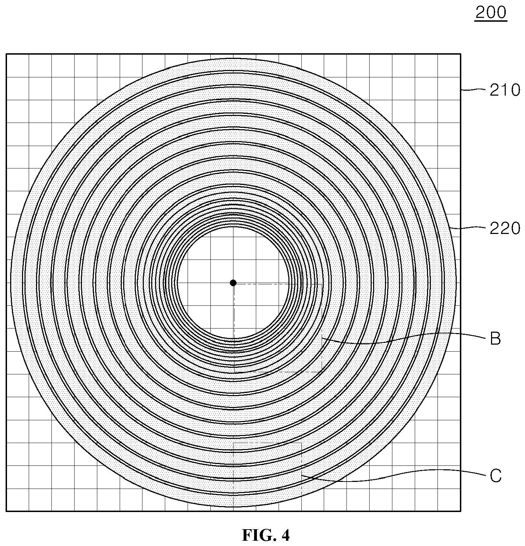

FIG. 4 is a view illustrating a coil substrate according to one embodiment of the present specification.

Referring to FIG. 4, a coil substrate 200 according to one embodiment of the present specification includes a substrate 210 and a coil 220.

The substrate 210 is a board on which an electric circuit whose wiring can be changed is organized. The substrate 210 may have electric elements, such as a resistor, a capacitor, and a coil, mounted on one surface, and the electric elements mounted on the substrate 210 may be connected to each other through wiring formed on the substrate 210.

In one embodiment of the present specification, the substrate 210 may be a printed circuit board (PCB).

The coil 220 is an element configured to generate a magnetic field therearound as current is applied. The coil 220 is mounted on one surface of the substrate 210. The coil 220 may operate like an inductor as current is supplied through the substrate 210. The coil 220 may be formed by being printed on the one surface of the substrate 210.

The coil 220 includes a plurality of turns. Here, the plurality of turns may have the same center. The plurality of turns may have a circular shape in one embodiment of the present specification, but the present specification is not limited thereto. That is, in another embodiment of the present specification, the plurality of turns may have any one shape that can form a closed curve, such as an elliptical shape and a quadrangular shape.

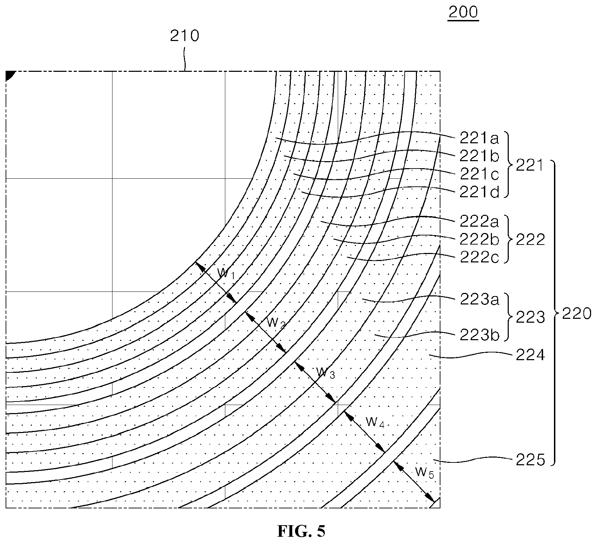

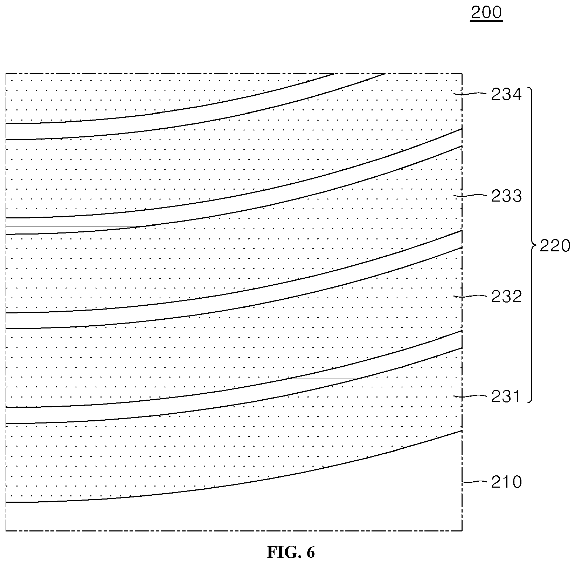

The plurality of turns include a first inner turn disposed at an innermost side of the coil 220 and a first outer turn disposed at an outermost side of the coil 220. Also, the first inner turn includes a larger number of patterns than the first outer turn. A more specific structure of the plurality of turns may be described with reference to FIGS. 5 and 6.

FIG. 5 is an enlarged view of portion "B" of FIG. 4. FIG. 6 is an enlarged view of portion "C" of FIG. 4.

FIG. 5 shows an enlarged view of an area in the vicinity of the center of the coil 220 mounted on the substrate 210.

The plurality of turns include a first inner turn 221 disposed at an innermost side of the coil 220. Here, the first inner turn 221 includes a plurality of patterns.

In one embodiment of the present specification, the plurality of patterns may be formed to come in contact with each other as illustrated in FIG. 5. Here, even when the plurality of patterns come in contact with each other, current may not flow through surfaces thereof in contact with each other.

Also, in another embodiment of the present specification, the plurality of patterns may be formed at small intervals from each other, unlike in FIG. 5.

That is, the plurality of patterns may be formed so that current flows through the wiring formed on the substrate 210 instead of directly flowing between the plurality of patterns.

In one embodiment of the present specification, the first inner turn 221 may include a first pattern 221a, a second pattern 221b, a third pattern 221c, and a fourth pattern 221d as illustrated in FIG. 5. However, the present specification is not limited thereto, and the first inner turn 221 may include an appropriate number of patterns so that heat generated in the area in the vicinity of the center of the coil 220 is reduced, and simultaneously, costs required for a manufacturing process are not too high.

Here, the plurality of patterns 221a, 221b, 221c, and 221d included in the first inner turn 221 may have the same width. In this way, it is possible to reduce processes and costs required when printing the plurality of patterns 221a, 221b, 221c, and 221d on the substrate 210.

Also, FIG. 6 shows an enlarged view of an area in the vicinity of the outer periphery of the coil 220 mounted on the substrate 210.

The plurality of turns include a first outer turn 231 disposed at an outermost side of the coil 220. Here, the first outer turn 231 includes a single pattern. That is, the first outer turn 231 includes a smaller number of patterns than the first inner turn 221.

In one embodiment of the present specification, the first outer turn 231 may include a single pattern. That is, the first outer turn 231 may be the same as the coil substrate 100 according to the related art illustrated in FIG. 1.

In this way, since the first inner turn 221 includes the plurality of patterns while the first outer turn 231 includes a single pattern, heat generated in the area in the vicinity of the center of the coil 220 may be reduced.

Referring back to FIG. 5, the plurality of turns include a second inner turn 222 disposed right outside the first inner turn 221. The second inner turn 222 may include a plurality of patterns. Here, the second inner turn 222 may include a larger number of patterns than the first outer turn 231 but include a smaller number of patterns than the first inner turn 221.

In one embodiment of the present specification, the second inner turn 222 may include a fifth pattern 222a, a sixth pattern 222b, and a seventh pattern 222c as illustrated in FIG. 5. However, the present specification is not limited thereto, and the second inner turn 222 may include an appropriate number of patterns within a range satisfying the above-described conditions so that heat generated in the area in the vicinity of the center of the coil 220 is reduced, and simultaneously, costs required for a manufacturing process are not too high.

Here, the plurality of patterns 222a, 222b, and 222c included in the second inner turn 222 may have the same width. In this way, it is possible to reduce processes and costs required when printing the plurality of patterns 222a, 222b, and 222c on the substrate 210.

Also, the plurality of turns include a third inner turn 223 disposed right outside the second inner turn 222. The third inner turn 223 may include a plurality of patterns. Here, the third inner turn 223 may include a larger number of patterns than the first outer turn 231 but include a smaller number of patterns than the second inner turn 222.

In one embodiment of the present specification, the third inner turn 223 may include an eighth pattern 223a and a ninth pattern 223b as illustrated in FIG. 5. However, the present specification is not limited thereto, and the third inner turn 223 may include an appropriate number of patterns within a range satisfying the above-described conditions so that heat generated in the area in the vicinity of the center of the coil 220 is reduced, and simultaneously, costs required for a manufacturing process are not too high.

Here, the plurality of patterns 223a and 223b included in the third inner turn 223 may have the same width. In this way, it is possible to reduce processes and costs required when printing the plurality of patterns 223a and 223b on the substrate 210.

In summary, the first inner turn 221 may have a larger number of patterns than the second inner turn 222, and the second inner turn 222 may have a larger number of patterns than the third inner turn 223. That is, the number of patterns may progressively decrease from a turn disposed at an inner side of the coil 220 toward a turn disposed at an outer side of the coil 220.

In this way, by allowing a turn disposed at an inner side of the coil 220 to have a larger number of patterns than a turn disposed at an outer side of the coil 220, heat generated in the area in the vicinity of the center of the coil 220 can be reduced.

Here, the plurality of turns included in the coil 220 may have the same width. That is, the first inner turn 221, the second inner turn 222, the third inner turn 223, a fourth inner turn 224 disposed right outside the third inner turn 223, and a fifth inner turn 225 disposed right outside the fourth inner turn 224 which are included in the coil 220 may have the same width. That is, a width W₁ of the first inner turn 221, a width W₂ of the second inner turn 222, a width W₃ of the third inner turn 223, a width W₄ of the fourth inner turn 224, and a width W₅ of the fifth inner turn 225 may all have the same value. Also, a turn not denoted by a reference numeral, the first outer turn 231, a second outer turn 232, a third outer turn 233, and a fourth outer turn 234 may also have the same width. In this way, each turn included in the coil 220 on the coil substrate 200 according to one embodiment of the present specification may be formed to have the same width but include a different number of patterns.

Also, the plurality of turns included in the coil 220 may have the same thickness. In this way, by the plurality of turns included in the coil 220 having the same width and thickness, processes and costs required when printing the plurality of turns on the substrate 210 can be reduced.

Also, referring back to FIG. 6, the plurality of turns include the second outer turn 232 disposed right inside the first outer turn 231. The second outer turn 232 may include the same number of patterns as the first outer turn 231. That is, like the first outer turn 231, the second outer turn 232 may include a single pattern.

In this way, by the turns disposed at an inner side of the coil 220 (for example, the first inner turn 221, the second inner turn 222, and the third inner turn 223) including a plurality of patterns and the turns disposed at an outer side of the coil 220 (for example, the first outer turn 231 and the second outer turn 232) including a single pattern, heat generated at the center of the coil 220 can be reduced.

In a case in which the coil 220 on the coil substrate 200 is formed as illustrated in FIGS. 4 to 6, a difference in power loss occurs as shown in Table 1 below, compared to a case in which the coil 120 on the coil substrate 100 is formed as illustrated in FIGS. 1 and 2.

**[Table 1]**

| Coil 120 of FIG. 1 | First turn 121 | Second turn 122 | Third turn 123 |
|---|---|---|---|
| Power loss [W] | 1.306 | 1.405 | 1.536 |
| Coil 220 of FIG. 4 | First inner turn 221 | Second inner turn 222 | Third inner turn 223 |
| Power loss [W] | 0.887 | 1.091 | 1.323 |
| Reduction amount [%] | 32.08 | 22.35 | 13.87 |

Referring to Table 1, in the case of the coil 120 of FIG. 1, power loss due to a first turn 121 is 1.306 W, power loss due to a second turn 122 is 1.405 W, and power loss due to a third turn 123 is 1.536 W. Also, in the case of the coil 220 of FIG. 4, power loss due to the first inner turn 221 is 0.887 W, power loss due to the second inner turn 222 is 1.091 W, and power loss due to the third inner turn 223 is 1.323 W.

Comparing the two cases, it can be seen that the amount of power loss is reduced by 32.08% in the first inner turn 221 as compared to the first turn 121, is reduced by 22.35% in the second inner turn 222 as compared to the second turn 122, and is reduced by 13.87% in the third inner turn 223 as compared to the third turn 123.

In this way, it can be seen that power loss is reduced by changing the number of patterns even for the turns present at the same position.

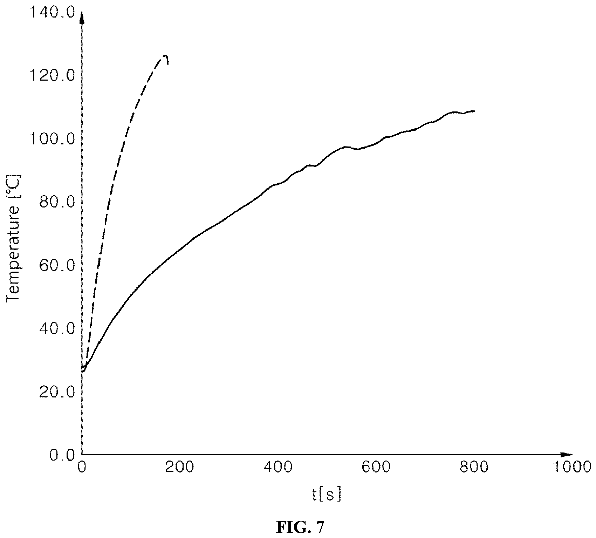

FIG. 7 is a graph showing changes in the temperature of the center of a coil when energy is transferred through the coil substrates according to one embodiment of the related art and one embodiment of the present specification.

FIG. 7 shows a graph showing changes in the temperature of the center of a coil over time when energy is transferred to different electronic devices through a coil substrate. Here, a dotted line graph is a graph showing a result in a case in which the coil substrate 100 according to one embodiment of the related art is used, and a sold line graph is a graph showing a result in a case in which the coil substrate 200 according to one embodiment of the present specification is used.

First, looking at the dotted line graph, it can be seen that the temperature sharply rises over time and exceeds 120 °C, and then the graph ends. The reason for the end of the graph is that, as the temperature of the center of the coil 120 exceeds 120 °C, an electronic device turns off due to an overheating prevention logic included in the electronic device, and thus measurement of the temperature of the center of the coil 120 ends.

Also, looking at the solid line graph, it can be seen that the slope of the temperature rise is gentler even over time, as compared to the case in which the coil substrate 100 according to one embodiment of the related art is used. That is, in the case in which the coil substrate 200 according to one embodiment of the present specification is used, it can be seen that, since the temperature of the center of the coil 220 does not sharply increase, an electronic device does not turn off due to an overheating prevention logic, and the temperature continues to be detected.

When the coil substrate 200 according to the present specification described above is used, since the first inner turn 221 includes a larger number of patterns than the first outer turn 231, excessive heat is not generated in the area in the vicinity of the center of the coil 220. Thus, energy loss of an electronic device using the coil substrate 200 can be reduced. Also, it is possible to prevent the electronic device using the coil substrate 200 from suddenly turning off.

The embodiments of the present specification have been described above with reference to the accompanying drawings, but the present specification is not limited by the embodiments and drawings disclosed herein, and it is apparent that various modifications may be made by those of ordinary skill in the art. Further, even if effects according to configurations of the present specification have not been explicitly described in the above description of the embodiments of the present specification, predictable effects of the corresponding configurations should also be acknowledged.

## Claims

1. A coil substrate (200) comprising:
a substrate (210); and
a coil (220) mounted on one surface of the substrate (210) and including a plurality of turns,
wherein the plurality of turns include a first inner turn (221) disposed at an innermost side of the coil (220) and a first outer turn (231) disposed at an outermost side of the coil (220), and
the first inner turn (221) includes a larger number of patterns than the first outer turn (231).

2. The coil substrate (200) of claim 1, wherein the plurality of turns have the same width.

3. The coil substrate (200) of claim 1, wherein:
the first inner turn (221) includes a plurality of patterns; and
the first outer turn (231) includes a single pattern.

4. The coil substrate (200) of claim 3, wherein the plurality of patterns included in the first inner turn (221) have the same width.

5. The coil substrate (200) of claim 1, wherein:
the plurality of turns further include a second inner turn (222) disposed right outside the first inner turn (221); and
the second inner turn (222) includes a larger number of patterns than the first outer turn (231) but includes a smaller number of patterns than the first inner turn (221).

6. The coil substrate (200) of claim 5, wherein:
the plurality of turns further include a third inner turn (223) disposed right outside the second inner turn (222); and
the third inner turn (223) includes a larger number of patterns than the first outer turn (231) but includes a smaller number of patterns than the second inner turn (222).

7. The coil substrate (200) of claim 1, wherein:
the plurality of turns further include a second outer turn (232) disposed right inside the first outer turn (231); and
the second outer turn (232) includes the same number of patterns as the first outer turn (231).

8. The coil substrate (200) of claim 1, wherein the plurality of turns have the same thickness.
